# EUROPEAN PATENT APPLICATION

(11) **EP 2 161 762 A1**
(43) Date of publication of application: **10.03.2010**
(21) Application number: 07816755.8
(22) Date of filing: 06.11.2007
(51) Int. Cl.: H01L 33/00

(54) **TIP LED**

(30) Priority: 30.05.2007 CN 200720052219 U
(71) Applicant: He Shan Lide Electronic Enterprise Company Ltd, He Shan, Guandong 529728 (CN)
(72) Inventor: FAN, Ben, Heshan, Guangdong 529728 (CN)
(74) Representative: Corradini, Corrado
(86) International application number: PCT/CN2007/003142
(87) International publication number: WO 2008/144974

(57) **Abstract**

A tip LED comprises a LED chip (1), a frame (2) and a encapsulation layer (3). The top portion of encapsulation layer (3) is a subwarhead shaped swivel (31). The height of swivel (31) is larger than radius of bottom thereof. The bottom diameter of swivel (31) is equal to diameter of root (32) of encapsulation layer (3). The distance from acme (311) of swivel (31) to LED chip (1) is 2.5-3.5 times than diameter of root (32) of encapsulation layer (3). The light emitted from LED chip (1) is concentrated to form a light point at the acme (311) of swivel (31).

## Description

### Background Of The Invention

The present invention relates to the field of LED packaging, and in particular to a bullet-shaped LED.

Light emitting diode has been widely used as a novel light source in many lighting areas. However, the light emitting diode needs to be encapsulated before use conveniently so that various packages are provided to change the light emission effect, such as light concentration or light diffusion, and so on. In several packaging solutions of light concentration, the round-headed LED is typically used, the upper portion of which is formed as a convex lens to focus light, which enables the LED bulb to be felt much brighter. Moreover, the visual effect will be better when used in decorative lighting. Regretfully, such LED also has its shortcomings: in prior art, the conventional package colloid always adopts epoxy resin with good light transmission characteristic, so that the side wall of which will form a reflection surface to reflect the light inside the package colloid thus only a little light can transmit the package colloid. Therefore, the bulb can not be felt brighter in other viewing angels but in front view , which leads to directional limitation of light. To solve this problem, people have already made some improvements on it. The light disperser such as phosphor is usually chosen to add into the package colloid . However, the cost increases, and the manufacturing process becomes more complex, which is not adapted to the mass production.

### Summary Of The Invention

To solve the aforementioned problems, the present invention provides a bullet-shaped LED capable of improving the light directional characteristic of the conventional LED, while avoids the increasing cost and improves the decoration effect of the LED bulb.

To achieve the above object, the present invention adopts the following technical solution:
a bullet-headed LED bulb comprising a frame, a LED chip being installed on the frame and a packaging layer provided on the top of the frame, wherein the upper portion of the packaging layer is a bullet-shaped rotating body, the height of the rotating body is greater than the radius of bottom surface of the rotating body. The LED chip is provided on the rotating axis of the rotating body. The root diameter of the packaging layer is equal to that of the bottom surface of the rotating body. The distance between the vertex of the rotating body and the LED chip is 2.5-3.5 times as large as the root radius of the packaging layer. A plurality of end caps having the same shape as the bullet-shaped rotating body are provided on the rotating body along the axis of the packaging layer. The end cap has 1∼2 layers, the 1∼2 layers overlap with the rotating body.

According to the technical solution described above, some light points corresponding to the LED chip can be formed at the vertex of the rotating body and the end caps. Such light points seem to be some "light sources" added in the LED bulb. The "light sources" provided at the vertex of the rotating body capable of radiating light to every direction freely so that enables people to feel the light in any direction and further improves the directional limitation of light in conventional LED package. Furthermore, it seems as if a plurality of "light sources" are arranged in array in one LED bulb when seen from its side view, and an excellent decoration effect can be achieved when such LED bulb is used in decorative lighting. In addition, the present invention merely changes the shape of the LED package colloid, so that it can be realized easily in manufacturing process without increasing the cost or complicating the process.

### Brief Description Of The Drawings

FIG.1 is the schematic view of the present invention.
FIG.2 is the sectional view of the present invention with one end cap.
FIG.3 is the sectional view of the present invention with two end caps.

### Detailed Description Of The Invention

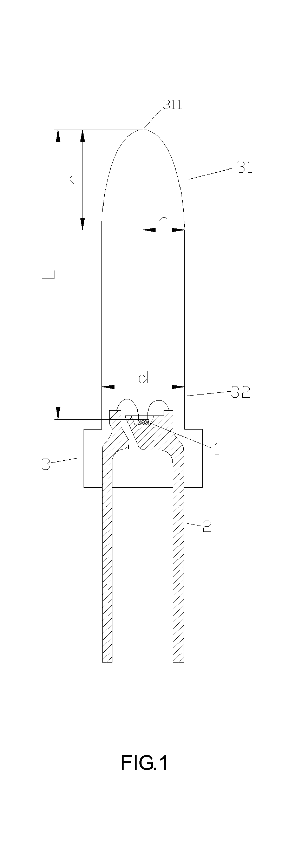

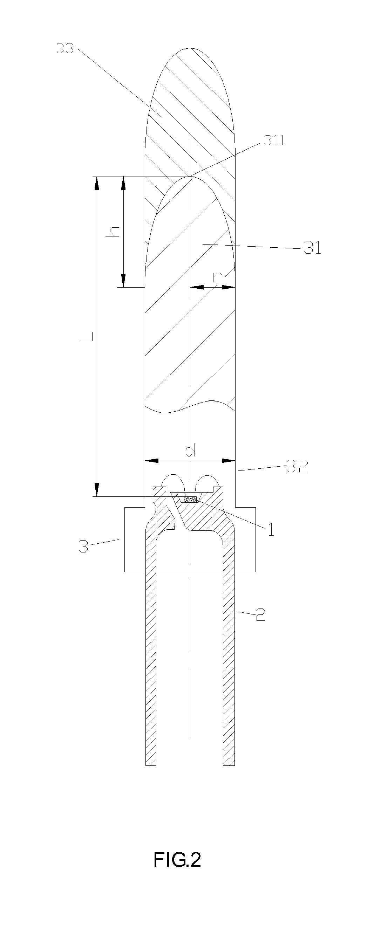

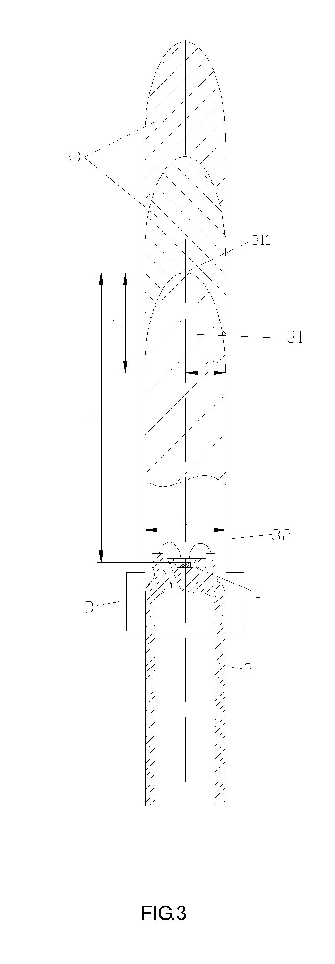

As shown in FIG.1, the bullet-shaped LED comprises the LED chip 1, lead frame 2 and packaging layer 3. The packaging layer 3 is made of transparent plastic such as epoxy resin. A bullet-shaped rotating body 31 is provided to be the upper portion of the packaging layer 3. The cross section of the rotating body 31 is parabola-shaped and similar to a half of the bullet head. As shown in FIG.1, the height h of the rotating body 31 is greater than the radius r of the bottom surface. The outside diameter of the rotating body 31 is equal to that of the packaging layer 3, that is, the diameter 2r of the bottom surface of the rotating body 31 is equal to the root diameter d of the packaging layer 3. In addition, the distance L between vertex 311 of the rotating body 31 and the LED chip 1 is 2.5-3.5 times as large as the root 32 diameter d of the packaging layer 3, 3 times is preferred, and the LED chip 1 is provided on the rotating axis of rotating body 31. Comparing with the conventional packaging layer, the packaging layer 3 is comparatively narrow and long and the overall appearance presents to be a bullet shape. When emitting light, the light of LED chip 1 is reflected by the interior wall of the packaging layer to form a light point at the vertex 311 of the rotating body 31. Such light point is similar to an artificial "light source", which cooperates with the original light source--LED chip to form two light emitting sources in appearance. Moreover, a plurality of end cap layers can be provided on the rotating body 31, and the conventional packaging process and packaging mould with predetermined shape can be adopted. The shape of the end cap 33 is identical to that of the bullet-shaped rotating body 31, which enables the end cap to be similar in geometrical shape and optical characters with respect to the rotating body. A plurality of end caps 33 overlap with the rotating body 31 along the direction of rotating axis of the packaging layer 3. When LED chip 1 emits light, the vertex of each end cap 33 forms an individual light point, thus many "light sources" arranged in array are obtained in appearance. However, the brightness of LED chip 1 is limited in a certain degree, so that a part of light will be wasted after refracted by rotating body 31 and end cap 33. Thus, the quantity of the end cap 33 should be controlled, otherwise the light point of the end cap 33 which is positioned faraway from the LED chip 1 will be very dim. The light point becomes dimmer gradually when the distance extends longer, and finally no light point occurs in appearance. Preferably, there are 1 or 2 pieces of the end caps 33. As shown in FIG.2, one end cap 33 is provided, and there will be 3 light points including the LED chip. As shown in FIG.3, two end caps 33 are provided, and there will be 4 light points including the LED chip.

The "light source" formed by optical characters and located at the top of the end cap 33 and the rotating body 31 is capable of emitting light in every direction, so that people can feel the light in any direction, which improves the directional limitation of light in conventional LED package. Furthermore, such LED bulb seems to possess a plurality of "light sources" as seen from its side view and such bullet-shaped head is attractive in appearance, so that an excellent decoration effect can be achieved when used in decorative lighting.

## Claims

1. A bullet-shaped LED bulb, comprising:
a frame;
a LED chip being installed on the frame;
a packaging layer provided on the top of the frame;
**characterized in that** the upper portion of the packaging layer is a bullet-shaped rotating body, the height of the rotating body is greater than the radius of bottom surface of the rotating body.

2. The bullet-shaped LED bulb of claim 1, **characterized in that** the LED chip is provided on the rotating axis of the rotating body.

3. The bullet-shaped LED bulb of claim 2, **characterized in that** the root diameter of the packaging layer is equal to the diameter of bottom surface of the rotating body.

4. The bullet-shaped LED bulb of claim 3, **characterized in that** the distance between the vertex of the rotating body and the LED chip is 2.5-3.5 times as large as the root diameter of the packaging layer.

5. The bullet-shaped LED bulb of claim 3, **characterized in that** a plurality of end caps having the same shape as the bullet-shaped rotating body are provided on the rotating body along the axis direction of the packaging layer.

6. The bullet-shaped LED bulb of claim 5, **characterized in that** the end cap has 1∼2 layers, the 1∼2 layers s overlap with the rotating body.
